# EUROPÄISCHE PATENTSCHRIFT

(11) **EP 0 981 937 B1**
(45) Veröffentlichungstag und Bekanntmachung des Hinweises auf die Patenterteilung: **28.08.2002**
(21) Anmeldenummer: 98929311.3
(22) Anmeldetag: 13.05.1998
(51) Int. Cl.: H05K 5/00, B60R 16/02, H05K 7/14

(54) **GEHÄUSE FÜR EINE ELEKTRONISCHE ODER ELEKTRISCHE SCHALTUNG**
HOUSING FOR AN ELECTRONIC OR ELECTRIC CIRCUIT
BOITIER POUR CIRCUIT ELECTRONIQUE OU ELECTRIQUE

(30) Priorität: 13.05.1997 DE 19719942
(43) Veröffentlichungstag der Anmeldung: 01.03.2000
(73) Patentinhaber: Continental ISAD Electronic Systems GmbH & Co. oHG, 86899 Landsberg/Lech (DE)
(72) Erfinder: GRÜNDL, Andreas, D-81377 München (DE); HOFFMANN, Bernhard, D-82319 Starnberg (DE)
(74) Vertreter: Schmidt, Steffen J., Dipl.-Ing.
(86) Internationale Anmeldenummer: EP9802844
(87) Internationale Veröffentlichungsnummer: WO98052394

(56) Entgegenhaltungen:
- DE-A- 4 129 238
- DE-A- 4 229 727
- DE-A- 19 634 523
- GB-A- 2 206 640
- ANZELONE T A ET AL: "DISCHARGE PATH FOR CASSETTE MODULE" IBM TECHNICAL DISCLOSURE BULLETIN, Bd. 23, Nr. 3, August 1980, Seite 877/878 XP002035156

## Beschreibung

Die vorliegende Erfindung betrifft ein Gehäuse für eine elektronische oder elektrische Schaltung. Insbesondere betrifft die vorliegende Erfindung ein Gehäuse für eine elektronische oder elektrische Schaltung, die im Motorraum eines Kraftfahrzeuges mit einem Verbrennungsmotor, vorzugsweise nahe bei dem Verbrennungsmotor selbst angeordnet ist bzw. sein muß.

Die Umgebungsbedingungen im Motorraum eines Kraftfahrzeuges sind für elektronische oder elektrische Schaltungen denkbar ungünstig. Vibrationen und Stöße in unterschiedlichen Richtungen und Intensitäten, Temperaturschwankungen zwischen -50 °C und +200 °C, Staub, Steinschlag, Spritzwasser, Feuchtigkeit, etc. treten im Inneren des Motorraums auf.

Ungeachtet dieser Bedingungen ist es erforderlich, daß die elektronischen oder elektrischen Schaltungen zuverlässig arbeiten, wobei in erheblichem Umfang nicht nur sicherheitsrelevante Funktionen, sondern auch leistungselektronische Schaltungen in Kraftfahrzeugen zunehmen.

In der betrieblichen Praxis sind Versuche bekannt geworden, wonach mittels spezieller Halbleiter (GaAs etc.) die maximale Betriebstemperatur von Silizium-Halbleitern von etwa 150 °C überwunden werden soll. Allerdings sind GaAs-Halbleiter sehr teuer und auch nicht für alle Anwendungsgebiete geeignet. Außerdem ist die hohe Umgebungstemperatur in der Nähe des Motorblocks des Verbrennungsmotors nur eine der zu überwindenden Schwierigkeiten.

Ausgehend hiervon liegt der Erfindung die Aufgabe zugrunde, eine Lösung für das Problem zu finden, im Motorraum eines Kraftfahrzeuges, in der Nähe des Motorblocks des Verbrennungsmotors, oder in einer ähnlich Umgebung mit ähnlichen Eigenschaften eine elektronische oder elektrische Schaltung anzuordnen.

Zur Lösung dieses Problems wird erfindungsgemäß folgende Lösung vorgeschlagen: Ein Gehäuse für eine elektronische oder elektrische Schaltung, die im Motorraum eines Kraftfahrzeuges, bei dem Motorblock des Verbrennungsmotors anzuordnen ist, mit einer ersten, inneren Schale, die fluiddicht und in einem vorbestimmten Druckbereich druckfest ist, und einer zweiten, die erste Schale zumindest teilweise umgebenden Schale, die von der ersten Schale zumindest für mechanische Stöße oder Vibrationen mit niedriger Frequenz entkoppelt ist.

Eine im Innern der ersten Schale angeordnete Federanordnung, die mit einem Trägerbauteil der elektronischen oder elektrischen Schaltung verbindbar ist und durch die die elektronische oder elektrische Schaltung von der ersten Schale zumindest für mechanische Stöße oder Vibrationen mit höher Frequenz entkoppelt ist, stellt eine Alternative für die Aufhängung der Schaltung in dem Gehäuse dar. Eine andere Alternative ist die Aufhängung der Schaltung an elektrischen und/oder hydraulischen Leitungen, die in die innere Schale hineinreichen. Diese Leitungen müssen in diesem Fall an der äußeren Schale abgestützt sein, so daß keine Schwingungen oder Stöße in die innere Schale eingetragen werden.

Der Erfindung liegt damit das Konzept zugrunde, eine zweistufige mechanische Entkopplung der elektronischen oder elektrischen Schaltung von dem Verbrennungsmotor vorzusehen, wobei die erste (äußere) Stufe einzeln auftretende Schockbelastungen auffängt und zweite (innere) Stufe Vibrationen absorbiert. Diese zweistufige mechanische Entkopplung bewirkt außerdem auch eine thermische Entkopplung der elektronischen oder elektrischen Schaltung von dem Verbrennungsmotor. Schließlich stellt das zweischalige Gehäuse auch einen Schutz gegen Steinschlag und dergl. sicher. Die Erfindung basiert demnach darauf, daß den unterschiedlichen Anforderungen (elektromagnetischer Schutz, mechanischer Schutz, Schwingungstilgung, thermischer Schutz, etc.) durch ein zweischaliges Gehäuse mit den oben genannten Merkmalen Rechnung getragen werden kann.

Weiterhin bewirkt das zweischalige Gehäuse, das zumindest teilweise aus Metall hergestellt ist, auch einen ausreichenden Schutz vor elektromagnetischer Emission und/oder Immission.

Vorzugsweise ist die erste Schale in einem Druckbereich von etwa 1 bar bis etwa 15 bar druckfest. Dies kann durch Versteifungen (Sicken, etc.) durch entsprechende Wanddicke, und/oder durch geeignete Materialwahl erreicht werden.

Eine derart gestaltete erste Schale kann zumindest teilweise mit einer inerten Kühlflüssigkeit gefüllt sein, die vorzugsweise einen niedrigen Siedepunkt hat und/oder FCKW-frei ist. Zusätzlich weist dabei die erste Schale wenigstens eine Verbindung zu einer Kühleinrichtung auf, die zum Aus- und/oder Einlaß von Kühlflüssigkeit bzw. Dampf der Kühlflüssigkeit eingerichtet ist. Damit kann im Innern der ersten Schale durch die elektronische oder elektrische Schaltung erzeugte Verlustwärme oder von außen eingetragene Wärme abgeführt werden. Die Kühleinrichtung kann ähnlich dem Kühler des Verbrennungsmotors gestaltet sein oder auch mit diesem gekoppelt oder identisch sein.

Vorzugsweise ist die zweite Schale von der ersten Schale durch einen Kunststoff-Faserverbund aus einem Kunststoff (z.B. Faserwolle aus Melaminharz oder dergl. )getrennt, der eine Temperaturbeständigkeit von wenigstens bis zu 200 °C aufweist. Melaminharz hat z.B. eine Zersetzungstemperatur von etwa 350 °C. Ein derartiger Faserverbund dient zwei Zwecken. Zum einen werden schockartige Stöße absorbiert. Zum anderen wirkt eine solche Faserwolle auch als thermische Isolierung.

Zwischen der ersten und der zweiten Schale kann ein schmaler Luftspalt von wenigen Millimetern Querabmessung vorgesehen sein. Dieser Luftspalt dient zusätzlich dazu, Vibrationen mit kleinerer Amplitude nicht vor der zweiten (äußeren) auf die erste (innere) Schale gelangen zu lassen.

Erfindungsgemäß ist die zweite Schale von der ersten Schale für mechanische Stöße oder Vibrationen mit Amplituden bis zu 30g/msec entkoppelt, während die elektronische oder elektrische Schaltung von der ersten Schale für Vibrationen mit Frequenzen von etwa 50 bis etwa 200 Hz entkoppelt ist.

Dabei ist erfindungsgemäß die Federanordnung im Innern der ersten Schale so gestaltet, daß zusammen mit der mechanischen Entkopplung der ersten von der zweiten Schale Stöße und/oder Vibrationen von bis zu etwa 10g(/msec) in alle Richtungen auf das Gehäuse einwirken können, ohne daß eine Beeinträchtigung der Funktion der elektronischen oder elektrischen Schaltung auftritt. Die Stöße und/oder Vibrationen können dabei sowohl durch den Verbrennungsmotor als auch durch Fahrtbewegungen des Kraftfahrzeuges gegenüber der Fahrbahn zustande kommen.

Weiterhin ist erfindungsgemäß das Gehäuse so gestaltet, daß die erste Schale wenigstens eine Verbindung zu einer elektrischen Stromversorgung und/oder zu einer weiteren elektronischen oder elektrischen Schaltung und/oder wenigstens einem elektrischen Verbraucher aufweist. Dabei kann der elektrische Verbraucher ein Elektromotor sein, der als Anlasser und/oder Schwingungstilger mit dem Verbrennungsmotor gekoppelt ist. Der elektrische Verbraucher kann jedoch auch ein oder mehrere elektrisch gesteuerte Ventile des Verbrennungsmotors sein, wodurch bisher üblicherweise verwendete kipphebelgesteuerte Ventile ersetzt werden. Die Verbindung zu der elektrischen Stromversorgung und/oder der Kühleinrichtung muß sowohl durch die erste als auch durch die zweite Schale des Gehäuses nach außen reichen. Um auch insofern eine thermische Entkopplung und eine Schwingungsentkopplung sicherzustellen, sind erfindungsgemäß dafür flexible und dehnbare (Well-)Schlauchleitungen vorgesehen, die von der ersten Schale durch die zweite Schale nach außen führen. Leitungen, die zu dem/den elektrischen Verbraucher/n führen, der in dem Verbrennungsmotor angeordnet sind, können auch an einer Stelle in das Innere des Verbrennungsmotors hineingeführt sein, die von der zweiten Schale überdeckt ist. Damit wird eine Quelle für Undichtigkeiten bzw. das Eindringen von Feuchtigkeit vermieden. Dies ist auch eine besonders bevorzugte Lösung im Hinblick auf Dichtheit für elektromagnetische Strahlungen.

In einer derzeit bevorzugten Ausführungsform der Erfindung weist das erste Gehäuse wenigstens einen zwei gegenüberliegende Wandabschnitte mit einander verbindenden Zugstab auf, an dem zumindest ein Teil der Federanordnung angeordnet ist. Damit erfüllt dieser Zugstab zwei Funktionen: Zum einen verhindert er eine Verformung des durch die Kühlflüssigkeit bzw. deren Dampf unter Druck stehenden Gehäuses. Zum anderen dient er als Aufhängung der elektronischen oder elektrischen Schaltung im Innern der ersten Schale, so daß die elektronische oder elektrische Schaltung im Innern der Schale für Bewegungen weitestgehend freigestellt ist.

Dabei durchdringt wenigstens ein Zugstab das Trägerbauteil der elektronischen oder elektrischen Schaltung und umgibt die Federanordnung den Zugstab zumindest teilweise, wobei ein erster Abschnitt der Federanordnung mit dem Zugstab verbunden ist, und ein zweiter Abschnitt der Federanordnung mit dem Trägerbauteil der elektronischen oder elektrischen Schaltung verbunden ist.

Bevorzugt weist die Federanordnung in unterschiedlichen Richtungen unterschiedliche Federsteifigkeiten auf. In einer Ausführungsform der Erfindung wird dies dadurch erreicht, daß die Federanordnung als Kegel-Schraubenfeder ausgestaltet ist. Es sind jedoch auch andere Ausgestaltungen der Federanordnung möglich, die die gleiche Funktion erfüllen.

In einer Ausführungsform der Erfindung ist das Gehäuse, und insbesondere die äußere Schale so gestaltet, daß es direkt an dem Motorblock eines Verbrennungsmotors, vorzugsweise an Stelle eines Anlassers anbringbar ist. Dies ermöglicht die Anbringung des Gehäuses auch in beengten räumlichen Gegebenheiten.

Vorzugsweise ist dabei die zweite Schale einseitig offen und weist mit der offenen Seite zu dem Motorblock hin. Die zweite Schale kann auch die Kupplungsglocke sein, die ohnehin am Verbrennungsmotor vorhanden ist. Die Erfindung kann somit durch Bereitstellen der inneren Schale sowie eines geeigneten Füllmaterials realisiert werden, wenn der Verbrennungsmotor eine Kupplungsglocke aufweist, die groß genug dimensioniert ist, daß sie die innere Schale sowie das Füll- bzw. Dämpfungsmaterial aufnehmen kann.

Um die elektrische Abschirmung gegen Störstrahlung zu verbessern oder herzustellen, liegt die zweite Schale mit einer elektrisch leitenden Dichtung an dem Motorblock an.

Gemäß einer bevorzugten Ausführungsform des Gehäuses ist dieses zur Aufnahme eines Wechselrichters für einen Elektromotor geeignet, der im Antriebsstrang zwischen dem Verbrennungsmotor und einer Kupplung angeordnet ist.

Die Erfindung betrifft auch ein Antriebsaggregat eines Kraftfahrzeuges nach Anspruch 19, mit einem Verbrennungsmotor, und einem Elektromotor, der im Antriebsstrang zwischen dem Verbrennungsmotor und einer Kupplung angeordnet ist, und mit einem Wechselrichter, der in einem Gehäuse mit einem oder mehreren der vorstehend beschriebenen Merkmale angeordnet ist.

Ersichtlich wird durch die Erfindung ein Gehäuse bereitgestellt, das den sicheren Betrieb einer elektronischen oder elektrischen Schaltung nahe bei oder direkt an einem Verbrennungsmotor ermöglicht. Für einen Fachmann ist jedoch auch klar, daß dieses Gehäuse nicht nur für mobile Verbrennungsmotoren geeignet ist, sondern auch für stationäre Verbrennungsmotoren. Grundsätzlich kann das Gehäuse stets dann mit Vorteil eingesetzt werden, wenn die Umgebungsbedingungen mit denen nahe an einem Verbrennungsmotor in einem Kraftfahrzeug vergleichbar sind.

Weitere Eigenschaften, Merkmale, Vorteile und Abwandlungen werden anhand der nachstehenden Beschreibung der Zeichnung deutlich, in denen Ausführungsbeispiele der Erfindung dargestellt sind.

Fig. 1 zeigt eine schematische Darstellung einer ersten Ausführungsform eines Gehäuses gemäß der Erfindung im Längsschnitt.

Fig. 2 zeigt eine schematische Darstellung der Ausführungsform des Gehäuses nach Fig. 1 im Querschnitt.

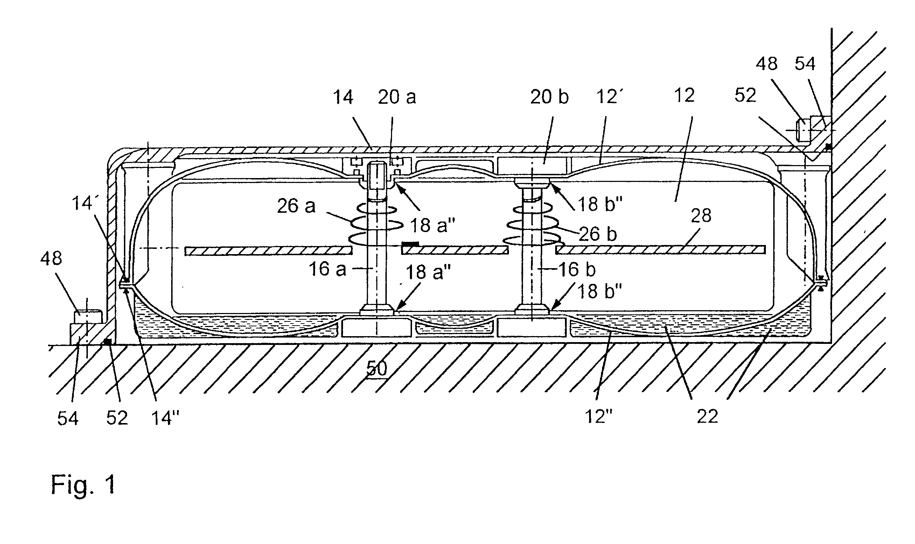

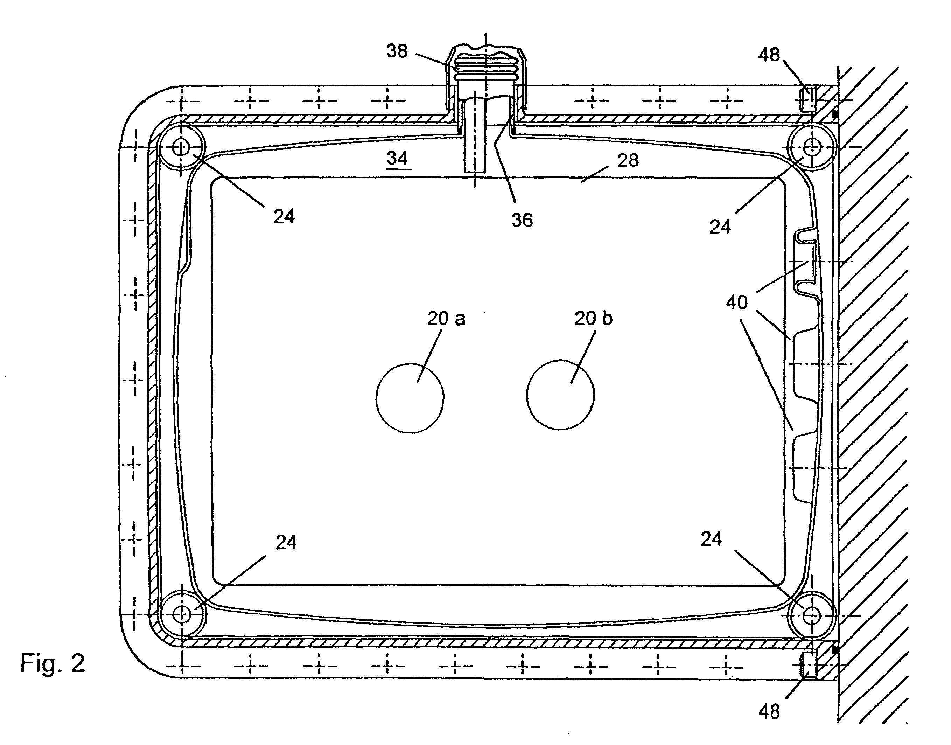

Fig. 1 und 2 zeigen ein Gehäuse 10 für eine elektronische oder elektrische Schaltung, die im Motorraum eines Kraftfahrzeuges, bei dem Motorblock des Verbrennungsmotors anzuordnen ist, mit einer ersten, inneren Schale 12, die fluiddicht und druckfest ist, und einer zweiten, die erste Schale 12 überdeckenden Schale 14.

Die erste Schale 12 ist durch zwei tiefgezogene Hälften 12', 12" aus Blech gebildet, die zusammen ein im wesentlichen quaderförmiges Gehäuse bilden. Zur Verbesserung der Stabilität und Druckfestigkeit ist die Gestalt des Gehäuses etwa kissenförmig. Weiterhin sind die beiden Hälften 12', 12" jeweils mit einem umlaufenden Rand 14', 14" versehen. Dort sind die beiden Hälften 12', 12" miteinander verschweißt, verlötet, verklebt oder gegeneinander verklemmt.

Zur weiteren Verbesserung der Stabilität und Druckfestigkeit des Gehäuses sind die beiden Hälften 12', 12" durch zwei Zugstäbe 16a, 16b miteinander verbunden. Dabei durchragen die beiden Zugstäbe 16a, 16b jeweils eine Öffnung 18a', 18b' in der einen Schalenhälfte 12' und jeweils eine Öffnung 18a", 18b" in der zweiten Schalenhälfte 12". Durch geeignete Verschraubungen 20a, 20b fixieren die beiden Zugstäbe 16a, 16b den Abstand der beiden Hälften 12', 12". Diese Maßnahmen sowie ggf. in die Schalenhälften 12', 12" eingearbeitete Sicken bewirken, daß die erste Schale 12 in einem Druckbereich von etwa 1 bar bis etwa 15 bar druckfest ist.

Die erste Schale 12 ist mit einem Füllmaterial 22 aus Melaminharzfasern umgeben, so daß es in der äußeren Schale 14 vollständig eingebettet ist. Zusätzlich sind - optional - in den vier Ecken der ersten Schale 12 Schwingungsdämpfer 24 aus elastischem Gummi oder dergl. angeordnet.

Das Füllmaterial 22 und/oder Schwingungsdämpfer 24 aus elastischem Gummi entkoppeln die erste Schale für mechanische Stöße oder Vibrationen mit niedriger Frequenz (von etwa 0,1 bis etwa 50 Hz) von der zweiten (äußeren) Schale 14.

Im Innern der ersten Schale 12 ist eine Federanordnung 26 bestehend aus zwei Kegel-Schraubenfedern 26a, 26b angeordnet. Die beiden Kegel-Schraubenfedern 26a, 26b sind an ihrem Ende mit ihrem kleineren Durchmesser jeweils an einem der Zugstäbe 16a, 16b verbunden und mit dem größeren Durchmesser mit einem Trägerbauteil 28 der elektronischen oder elektrischen Schaltung verbindbar. Dazu weist das Trägerbauteil, im vorliegenden Beispiel eine Platine 28, Öffnungen 30a, 30b auf, durch die die Zugstäbe 16a, 16b jeweils hindurchragen. Dabei sind die Öffnungen 30a, 30b so dimensioniert, daß das Trägerbauteil 28 an den Kegel-Schraubenfedern 26a, 26b um die Zugstäbe 16a, 16b taumeln kann.

Durch die Kegel-Schraubenfedern 26a, 26b ist die elektronische oder elektrische Schaltung von der ersten Schale 12 für mechanische Stöße oder Vibrationen mit hoher Frequenz (etwa 50 bis etwa 200 Hz) entkoppelt ist.

Die erste Schale 12 ist teilweise mit einer inerten Kühlflüssigkeit gefüllt, die einen niedrigen Siedepunkt hat. Wie in Fig. 2 zu sehen ist, verbleibt dabei über der Platine 28 ein Freiraum 34, in dem sich der Dampf aus der inerten Kühlflüssigkeit sammeln und durch eine Verbindung 36 in der ersten Schale 12 zu einer Kühleinrichtung (nicht gezeigt) entweichen kann. Dabei ist der Verbindung 36 als Flansch für einen Wellschlauch 38 ausgestaltet durch den Kühlflüssigkeit bzw. Dampf der Kühlflüssigkeit in die Schale 12 ein- bzw. ausströmen kann. Dabei kann der Wellschlauch 38 aus Kunststoff oder aus Metall sein. Ein Metall-Wellschlauch 38 hat den zusätzlichen Effekt der elektromagnetischen Abschirmung und der geringeren Temperaturempfindlichkeit.

Weiterhin weist die erste Schale 12 einen Verbindungsflansch 40 zu einer elektrischen Stromversorgung (nicht gezeigt) und/oder zu einer weiteren elektronischen oder elektrischen Schaltung (nicht gezeigt) und/oder einem elektrischen Verbraucher (nicht gezeigt) auf. Dabei kann die Formgebung der Schalenhälften 12', 12" so sein, daß die Durchbrüche oder Verbindungsflansche 36, 36 lediglich in einer Hälfte vorhanden sind.

Die äußere Schale 14 des Gehäuses ist so gestaltet, daß es direkt an dem Motorblock eines Verbrennungsmotors 50, an Stelle eines Anlassers mittels mehrerer Schrauben 48 angebracht werden kann. Dazu ist die zweite Schale 14 einseitig offen und weist mit der offenen Seite zu dem Motorblock hin.

Damit auch die äußere Schale 14 als elektromagnetische Abschirmung wirkt, ist die zweite Schale 14 an ihrem Rand 54 mit einer elektrisch leitenden Dichtung 52 versehen und liegt dicht an dem Motorblock an.

Die erfindungsgemäße, zweischalige Ausführung des Gehäuses für die elektrische oder elektronische Schaltung dient der gleichzeitigen Erfüllung der gleichwertigen Aufgaben:
- mechanischer Schutz (Steinschlag und dergl.),
- thermischer Schutz (wobei das Isolationsmaterial im Raum zwischen der ersten und der zweiten Schale auch mechanisch geschützt ist),
- Schutz gegen Vibrationen und Schock,
- EMV-Schutz (die äußere Schale kann auf das gleiche elektrische Potential wie der Verbrennungsmotor gebracht werden),
- elektrische Leitungen können auf einfache Weise aus dem inneren (fluiddichten) Gehäuse herausgeführt werden und noch im Schutz der äußeren Schale in den Verbrennungsmotor eingeleitet werden, so daß eine zweistufige Durchführung elektrischer Leitungen großteils nicht erforderlich ist,
- von außen durch die äußere Schale in die innere Schale reichende Fluid- oder elektrische Leitungen können an der äußeren Schale so aufgehängt werden, daß keine Schwingungen oder Stöße in das Innere der inneren Schale eingetragen werden.

Da durch das zweischalige Gehäuse eine Kühlung der inneren Schale auf übliche Außen-Umgebungsbedingungen möglich ist, wird durch die erfindungsgemäße Anordnung ein Raum mit annähernd Außentemperatur in unmittelbarer Nähe des Motorblocks eines Kraftfahrzeugs geschaffen.

## Patentansprüche

1. Gehäuse für eine elektronische oder elektrische Schaltung, die im Motorraum eines Kraftfahrzeuges, bei dem Motorblock des Verbrennungsmotors anzuordnen ist, mit
- einer ersten, inneren Schale (12), die fluiddicht und in einem vorbestimmten Druckbereich druckfest ist, und
- einer zweiten, die erste Schale (12) zumindest teilweise umgebenden Schale (14), die von der ersten Schale (12) zumindest für mechanische Stöße oder Vibrationen mit niedriger Frequenz entkoppelt ist.

2. Gehäuse nach Anspruch 1, **gekennzeichnet durch**
- eine im Innern der ersten Schale (12) angeordnete Federanordnung (26), die mit einem Trägerbauteil (28) der elektronischen oder elektrischen Schaltung verbindbar ist und **durch** die die elektronische oder elektrische Schaltung von der ersten Schale (12) zumindest für mechanische Stöße oder Vibrationen mit hoher Frequenz entkoppelt ist.

3. Gehäuse nach Anspruch 1, **dadurch gekennzeichnet, daß**
die im Inneren der ersten Schale (12) angeordnete elektronische oder elektrische Schaltung über elastische elektrische oder Fluid-Leitungen gelagert ist.

4. Gehäuse nach Anspruch 1, **dadurch gekennzeichnet, daß**
- die erste Schale (12)) in einem Druckbereich von etwa 1 bar bis etwa 15 bar druckfest ist,

5. Gehäuse nach Anspruch 1, **dadurch gekennzeichnet, daß**
- die zweite Schale (14) von der ersten Schale (12) für mechanische Stöße oder Vibrationen bis Amplituden von 30g/msec entkoppelt ist.

6. Gehäuse nach Anspruch 1, **dadurch gekennzeichnet, daß**
- die elektronische oder elektrische Schaltung von der ersten Schale (12) zumindest für mechanische Stöße oder Vibrationen mit Frequenzen von etwa 50 bis etwa 200 Hz entkoppelt ist.

7. Gehäuse nach Anspruch 1, **dadurch gekennzeichnet, daß**
- die erste Schale (12) zumindest teilweise mit einer inerten Kühlflüssigkeit gefüllt ist, die vorzugsweise einen niedrigen Siedepunkt hat, und
- die erste Schale (12) wenigstens eine Verbindung (36) zu einer Kühleinrichtung aufweist, die zum Aus- und/oder Einlaß von Kühlflüssigkeit bzw. Dampf der Kühlflüssigkeit eingerichtet ist.

8. Gehäuse nach Anspruch 1, **dadurch gekennzeichnet, daß**
- die erste Schale (12) wenigstens eine Verbindung (40) zu einer elektrischen Stromversorgung und/oder zu einer weiteren elektronischen oder elektrischen Schaltung und/oder wenigstens einem elektrischen Verbraucher aufweist.

9. Gehäuse nach Anspruch 1, **dadurch gekennzeichnet, daß**
- die zweite Schale (14) von der ersten Schale (12) durch einen Kunststoff-Faserverbund (22) aus einem Kunststoff getrennt ist, der eine Temperaturbeständigkeit von wenigstens bis zu 150 °C aufweist.

10. Gehäuse nach Anspruch 2, **dadurch gekennzeichnet, daß**
- die Federanordnung (26) im Innern der ersten Schale (12) so gestaltet ist, daß zusammen mit der mechanischen Entkopplung (22) der ersten (12) von der zweiten Schale (14) Stöße und/oder Vibrationen von bis zu etwa 10 g/msec in alle Richtungen auf das Gehäuse einwirken können, ohne daß eine Beeinträchtigung der Funktion der elektronischen oder elektrischen Schaltung auftritt.

11. Gehäuse nach Anspruch 2, **dadurch gekennzeichnet, daß**
- die erste Schale (12) wenigstens einen zwei gegenüberliegende Wandabschnitte (12', 12") mit einander verbindenden Zugstab (16a, 16b) aufweist, an dem vorzugsweise zumindest ein Teil der Federanordnung (26) angeordnet ist.

12. Gehäuse nach Anspruch 11, **dadurch gekennzeichnet, daß**
- wenigstens ein Zugstab (16a, 16b) das Trägerbauteil (28) der elektronischen oder elektrischen Schaltung durchdringt und die Federanordnung (26a, 26b) den Zugstab (16a, 16b) zumindest teilweise umgibt, wobei ein erster Abschnitt der Federanordnung (26a, 26b) mit dem Zugstab (16a, 16b) verbunden ist, und ein zweiter Abschnitt der Federanordnung (26a, 26b) mit dem Trägerbauteil (28) der elektronischen oder elektrischen Schaltung verbindbar ist.

13. Gehäuse nach Anspruch 12, **dadurch gekennzeichnet, daß**
- die Federanordnung (26a, 26b) in unterschiedlichen Richtungen unterschiedliche Federsteifigkeiten aufweist.

14. Gehäuse nach Anspruch 13, **dadurch gekennzeichnet, daß**
- die Federanordnung als Kegel-Schraubenfeder (26a, 26b) ausgestaltet ist.

15. Gehäuse nach Anspruch 1, **dadurch gekennzeichnet, daß**
- das Gehäuse so gestaltet ist, daß es direkt an dem Motorblock eines Verbrennungsmotors, vorzugsweise an Stelle eines Anlassers anbringbar ist.

16. Gehäuse nach Anspruch 15, **dadurch gekennzeichnet, daß**
- die zweite Schale (14) einseitig offen ist und mit der offenen Seite zu dem Motorblock hinweist.

17. Gehäuse nach Anspruch 16, **dadurch gekennzeichnet, daß**
- die zweite Schale (14) mit einer elektrisch leitenden Dichtung (52) an dem Motorblock anliegt.

18. Gehäuse nach Anspruch 16, **dadurch gekennzeichnet, daß**
- es zur Aufnahme eines Wechselrichters für einen Elektromotor geeignet ist, der im Antriebsstrang zwischen dem Verbrennungsmotor und einer Kupplung angeordnet ist.

19. Antriebsaggregat eines Kraftfahrzeuges, mit einem Verbrennungsmotor, und einem Elektromotor, der im Antriebsstrang zwischen dem Verbrennungsmotor und einer Kupplung angeordnet ist, und mit einem Wechselrichter, der in einem Gehäuse nach einem der vorhergehenden Ansprüche angeordnet ist.

## Claims

1. A housing for an electronic or electric circuit to be arranged in the engine compartment of a motor vehicle at the engine block of the internal combustion engine, comprising
- a first inner tray (12) which is fluid-tight and pressure-proof in a predetermined pressure range,
- a second tray (14) which surrounds the first tray (12) at least partially and is uncoupled from the first tray (12) at least for mechanical impact or low frequency vibrations.

2. The housing according to claim 1, **characterised by**
- a spring arrangement (26) which is arranged in the interior of the first tray (12), is adapted to be connected with a support component (28) of the electronic or electric circuit and by which the electronic or electric circuit is uncoupled from the first tray (12) at least for mechanical impact or high-frequency vibrations.

3. The housing according to claim 1, **characterised in that** the electronic or electric circuit arranged in the interior of the first tray (12) is supported via resilient, electric or fluid lines.

4. The housing according to claim 1, **characterised in that**
- the first tray (12) is pressure-proof in a pressure range of about 1 bar to about 15 bar.

5. The housing according to claim 1, **characterised in that**
- the second tray (14) is uncoupled from the first tray (12) for mechanical impact or vibrations up to amplitudes of 30g/msec.

6. The housing according to claim 1, **characterised in that**
- the electronic or electric circuit is uncoupled from the first tray (12) at least for mechanical impact or vibrations having frequencies of about 50 up to about 200 Hz.

7. The housing according to claim 1, **characterised in that**
- the first tray (12) is at least partially filled with an inert cooling fluid preferably having a low boiling point, and
- the first tray (12) has at least one connection (36) to a cooling means adapted to let out and/or let in cooling fluid or vapour of the cooling fluid.

8. The housing according to claim 1, **characterised in that**
- the first tray (12) has at least one connection (40) to an electric current supply and/or to a further electronic or electric circuit and/or at least one electric consumer.

9. The housing according to claim 1, **characterised in that**
- the second tray (14) is separated from the first tray (12) by a synthetic material fibre compound (22) of one synthetic material having temperature stability up to at least 150°C.

10. The housing according to claim 2, **characterised in that**
- the spring arrangement (26) in the interior of the first tray (12) is configured in such a manner that together with the mechanical uncoupling (22) of the first tray (12) from the second tray (14) impact and/or vibrations of up to about 10 g/msec may act on the housing from all directions without the function of the electronic or electric circuit being affected.

11. The housing according to claim 2, **characterised in that**
- the first tray (12) comprises at least one tension rod (16a, 16b) connecting two oppositely located wall sections (12', 12") with each other, at which preferably at least part of the spring arrangement (26) is arranged.

12. The housing according to claim 11, **characterised in that**
- at least one tension rod (16a, 16b) penetrates the support component (28) of the electronic or electric circuit and the spring arrangement (26a, 26b) surrounds the tension rod (16a, 16b) at least partially, a first section of the spring arrangement (26a, 26b) being connected with the tension rod (16a, 16b) and a second section of the spring arrangement (26a, 26b) being adapted to be connected with the support component (28) of the electronic or electric circuit.

13. The housing according to claim 12, **characterised in that**
- the spring arrangement (26a, 26b) has different spring rigidities in different directions.

14. The housing according to claim 13, **characterised in that**
- the spring arrangement is designed as a cone-type helical spring (26a, 26b).

15. The housing according to claim 1, **characterised in that**
- the housing is designed in such a manner that it can be directly attached at the engine block of an internal combustion engine, preferably in the place of a starter.

16. The housing according to claim 15, **characterised in that**
- the second tray (14) is open at one side and that said open side faces the engine block.

17. The housing according to claim 16, **characterised in that**
- the second tray (14) abuts the engine block by way of an electrically conductive seal (52).

18. The housing according to claim 16, **characterised in that**
- it is adapted to receive an inverted rectifier for an electromotor, which is arranged in the driving line between the internal combustion engine and a clutch.

19. A driving assembly of a motor vehicle, comprising an internal combustion engine and an electromotor that is arranged in the driving line between the internal combustion engine and a clutch, and comprising an inverted rectifier arranged in a housing according to one of the preceding claims.

## Revendications

1. Boîtier pour un circuit électronique ou électrique, lequel est destiné à être monté dans le compartiment moteur d'un véhicule automobile, près du bloc-cylindres du moteur à combustion, comprenant
- une première enveloppe intérieure (12) étanche vis-à-vis des fluides et résistante à la pression dans une plage de pression déterminée, et
- une deuxième enveloppe (14) entourant au moins partiellement la première enveloppe (12) et qui est découplée de la première enveloppe (12) au moins pour les chocs ou vibrations mécaniques de basse fréquence.

2. Boîtier selon la revendication 1, **caractérisé en ce que**
- un agencement à ressort (26) est ménagé à l'intérieur de la première enveloppe (12), lequel peut être raccordé à un élément porteur (28) du circuit électronique ou électrique et permet de découpler le circuit électronique ou électrique de la première enveloppe (12) au moins pour les chocs ou vibrations mécaniques de haute fréquence.

3. Boîtier selon la revendication 1, **caractérisé en ce que** le circuit électronique ou électrique disposé à l'intérieur de la première enveloppe (12) est maintenu en position au moyen de conduites électriques ou conduites de fluides élastiques.

4. Boîtier selon la revendication 1, **caractérisé en ce que**
- la première enveloppe (12) résiste à l'épreuve de la pression dans une plage de pression allant d'environ 1 bar à environ 15 bar.

5. Boîtier selon la revendication 1, **caractérisé en ce que**
- la deuxième enveloppe (14) est découplée de la première enveloppe (12) pour les chocs ou vibrations mécaniques jusqu'à 30g/msec d'amplitude.

6. Boîtier selon la revendication 1, **caractérisé en ce que**
- le circuit électronique ou électrique est découplé de la première enveloppe (12) au moins pour les chocs ou vibrations mécaniques à des fréquences d'environ 50 à environ 200 Hz.

7. Boîtier selon la revendication 1, **caractérisé en ce que**
- la première enveloppe (12) est au moins partiellement remplie d'un liquide de refroidissement inerte, lequel affiche de préférence un point d'ébullition bas et
- la première enveloppe (12) affiche au moins une liaison (36) vers le dispositif de refroidissement conçu pour permettre l'évacuation et/ou l'admission du liquide de refroidissement ou de la vapeur provenant du liquide de refroidissement.

8. Boîtier selon la revendication 1, **caractérisé en ce que**
- la première enveloppe (12) affiche au moins une liaison (40) vers une alimentation électrique et/ou un autre circuit électronique ou électrique et/ou au moins un récepteur électrique.

9. Boîtier selon la revendication 1, **caractérisé en ce que**
- la deuxième enveloppe (14) est séparée de la première enveloppe (12) par un composite fibreux (22) en synthétique accusant une tenue en température jusqu'à au moins 150°C.

10. Boîtier selon la revendication 2, **caractérisé en ce que**
- l'agencement à ressort (26) ménagé à l'intérieur de la première enveloppe (12) est conçu de telle façon que, conjointement avec le découplage mécanique (22) entre la première (12) et la deuxième enveloppe (14), les chocs et/ou les vibrations jusqu'à environ 10g/msec d'amplitude puissent agir dans tous les sens sur le boîtier sans altérer les fonctions du circuit électronique ou électrique.

11. Boîtier selon la revendication 2, **caractérisé en ce que**
- la première enveloppe (12) affiche au moins un tirant (16) reliant l'une à l'autre deux sections de paroi (12', 12'') opposées et sur lequel est de préférence disposée au moins une partie de l'agencement à ressort (26).

12. Boîtier selon la revendication 11, **caractérisé en ce que**
- au moins un tirant (16a, 16b) traverse l'élément porteur (28) du circuit électronique ou électrique et l'agencement à ressort (26a, 26b) entoure au moins partiellement le tirant (16a, 16b), une première partie de l'agencement à ressort (26a, 26b) étant reliée au tirant (16a, 16b), et une deuxième partie de l'agencement à ressort (26a, 26b) pouvant être raccordée à l'élément porteur (28) du circuit électronique et électrique.

13. Boîtier selon la revendication 12, **caractérisé en ce que**
- l'agencement à ressort (26a, 26b) affiche des raideurs de ressort différentes dans des directions différentes.

14. Boîtier selon la revendication 13, **caractérisé en ce que**
- l'agencement à ressort est formé par un ressort conique (26a, 26b)

15. Boîtier selon la revendication 1, **caractérisé en ce que**
- le boîtier est conçu de manière à pouvoir être monté directement sur le bloc-cylindres d'un moteur à combustion, de préférence à la place d'un démarreur.

16. Boîtier selon la revendication 15, **caractérisé en ce que**
- la deuxième enveloppe (14) présente un côté ouvert tourné vers le bloc-cylindres du moteur.

17. Boîtier selon la revendication 16, **caractérisé en ce que**
- la deuxième enveloppe (14) se trouve en contact avec le bloc-cylindres du moteur au moyen d'un joint (52) conducteur.

18. Boîtier selon la revendication 16, **caractérisé en ce que**
- il se prête au logement d'un onduleur pour un moteur électrique, lequel est disposé sur l'arbre moteur entre le moteur à combustion et un accouplement.

19. Groupe moteur d'un véhicule automobile, comprenant un moteur à combustion et un moteur électrique disposé sur l'arbre moteur entre le moteur à combustion et un accouplement, et comprenant un onduleur disposé dans un boîtier suivant l'une des revendications précédentes.
